# EUROPEAN PATENT APPLICATION

(11) **EP 3 323 543 A1**
(43) Date of publication of application: **23.05.2018**
(21) Application number: 17460064.3
(22) Date of filing: 19.10.2017
(51) Int. Cl.: B23K 1/00, B23K 3/047, H01R 43/02, H05K 3/34, B23K 101/42

(54) **MODULE FOR SOLDERING PRINTED CIRCUIT BOARDS**

(30) Priority: 17.11.2016 PL 41949816
(71) Applicant: Instytut Odlewnictwa, 30-418 Kraków (PL)
(72) Inventor: SOBCZAK, Natalia, 32-020 Wieliczka (PL); KUDYBA, Artur, 30-698 Kraków (PL); MARKIEWICZ, Michal, 20-314 Lublin (PL)
(74) Representative: Bartula-Toch, Marta

(57) **Abstract**

The module for soldering printed circuit boards consists of two horizontal, parallel and movable heating plates (2) and (5), placed in enclosures made of a low thermal expansion material of 20-300°C. The surface of each plate has a system of densely distributed identical openings that constitute sockets for sliding heating rods (1) with adjustable extension above the heating plate level, of which the ends, directed into the space between plates (2) and (6), are made of ceramic material or metal. The rod (1) has one or more openings parallel to its longitudinal axis, in which the central opening holds a heating element and/or thermocouple, while additionally the openings constitute a duct for the gas, of which the flow is forced by a fan (7) installed at heating rod socket inlets (1), or the rod (1) has a heating element installed at its end.

## Description

The subject of the solution is a module for soldering printed circuit boards with unleaded solder with a reduced silver content.

As electronics developed, precise and flawless mass production of electronic circuits, which are indispensable part of any electronic device, became an essential challenge.

A significant part of the process of manufacture of those boards is soldering, which is often the main source of defects that occurred at the manufacturing stage. The application of an excessively high temperature for the solder type causes board deformation.

Patent applications reveal many methods and devices for soldering printed circuit boards.

The patent description no. US 2770875 reveals a method and a device for soldering that enable the application of solder onto metallised surfaces of printed circuits and soldering components onto the surface of printed circuit boards. The solution enables simultaneous soldering of connections on one or two sides of the printed circuit boards with local solder application. Circuit boards are placed on the belt conveyor with individual soldering process stations by its side - a station for applying solder equipped with solder application components, a station for applying components on circuit boards and a station for soldering. Under every two soldering stations there is a molten solder tank. Furthermore, the soldering stations is equipped with a platform with many protruding soldering components that conduct heat. This platform is lowered into the molten solder tank and then lifted towards the circuit board at the soldering station. Every soldering components is designed to enable drawing a small amount of solder from the tank while lowering the platform.

The patent application no. DE 102012111946 reveals a solution related to a device enabling selective soldering. A device based on the invention consists of a soldering bath with molten solder, at least one soldering nozzle, nozzle shifting components and a component for feeding the work-piece to the place of soldering. Soldering nozzles can be shifted independently and operate simultaneously based on instructions from various programmes, which enables simultaneous soldering of multiple components. After selecting an appropriate programme, the soldering process begins by coating the printed circuit board with solder, heating it and correcting its position. Next the board is subject to wave soldering and then the board with soldered components undergoes automatic visual control. At the final process stage, the board is subject to cooling.

The patent description no. US 6655574 reveals a device for selective soldering. The device based on the invention consists of a molten solder tank for heating the solder, work-piece transport components, at least one pipe, into which molten solder is pumped through the outlet with a pump, and moving components, which enable contact of a work-piece with the upper edge of the pipe. The outlet is placed at a certain distance from the upper edge of the pipe, so the solder outflow has no direct contact with the printed circuit board and components. In the description of this invention, the pipe constitutes a kind of apparatus for wave soldering. This device, contrary to the proposed invention, uses another method of soldering. It is not possible to adjust the soldering temperature for specific components.

The subject of the patent application no. WO 2007138310 is a device for selective soldering. The device consists of a soldering bath, a nozzle for solder application and a pump for pumping the solder to the nozzle. The nozzle consists of a body with a solder flow duct inside.

The nozzle body is surrounded by a guard that enables the return flow of solder excess to the soldering bath.

The selections presented above do not enable simultaneous installation of many components on the board, while maintaining the local nature of the soldering process.

The essence of this invention is that the soldering module consists of two horizontal, parallel, moving heating plates, placed in enclosures of a low thermal expansion material of 20-300°C, whereas the surface of each plate has a system of densely distributed identical openings, which constitute sockets for moving heating rod with an adjustable extension above the plate level. The ends of the heating rods directed into the space between plates are made of ceramic material. Each rod has one or more openings, longitudinally and in parallel to its axis, whereas the central opening includes a heating element and/or a thermocouple. The openings form cooling gas flow ducts, forced to move by a fan installed near heating rod socket inlets. Alternatively, heating rods have heating elements installed at their ends. Preferably, heating rod sockets and heating rods are threaded. Preferably, the heating element consists of a resistance wire.

The main advantage of the solution based on this invention is the fact that the heating elements of the rods mounted to the soldering plate can operate independently, so each heating element can be heated to a temperature different from other rods. The selective setting of heating element temperatures enables the management of the soldering process with granulation into individual circuit lands. The rods placed above the components cannot be heated at all to prevent electronic components from unnecessary exposure to high temperatures. The rods placed directly by circuit lands are heated to a temperature enabling the soldering process. The solder used in the process of soldering with the proposed solution can have a higher melting point than the melting point of the Pb-Sn eutectic alloy and even higher than the temperature of the SAC-type solder, even though electronic components are not exposed to an excessive impact of high temperature, since the scope of temperature impact is to a large extent local and limited to circuit lands and rod ends. The heating element placed at the end of the rod has a low thermal capacity, so the shut down of the power supply is followed by a relatively quick temperature drop.

Since the space between heating elements and circuit lands is very limited, it is possible to obtain a quick increase of the temperature of a circuit land, placed directly under the heating element. To obtain the cooling gradients required in the technological process, the heating plate, in which rods are seated, is preferably moving, which enables extending the space between heated rods and the PCB surface at the cooling stage. With such solution, the components seated on the PCB, as well as the PCB itself, can radiate heat more efficiently. To increase the PCB cooling rate, gas can be pumped through openings in the plate, but also through opening at the ends of the rods.

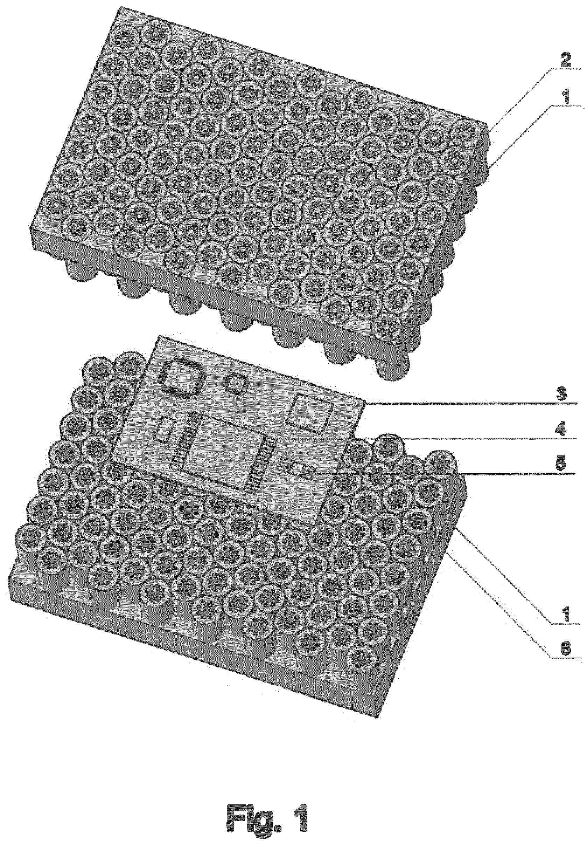

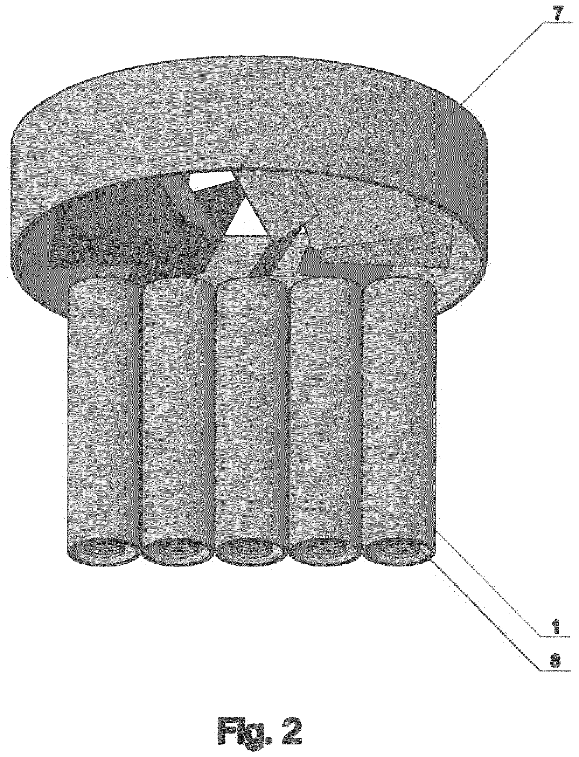

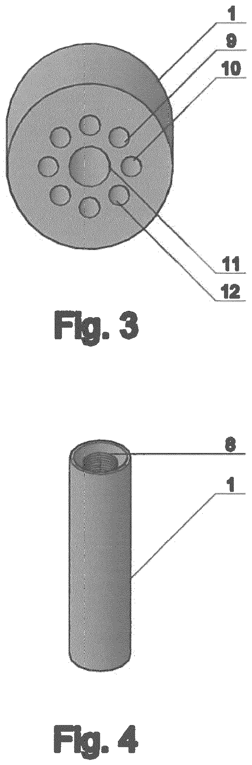

The subject of this invention is presented in the embodiment on figures, in which fig. 1 is a view of two soldering plates with the PCB, fig. 2 is a view of rod sockets and the fan, fig. 3 is a cross-section of a rod socket, fig. 4 is a view of the heating element with the central opening of the heating rod.

Soldering plates are installed so that the upper soldering plate 2 and the lower soldering plate 6 are positioned horizontally and in parallel to the work-piece, in this embodiment: the PCB 3. Soldering plates 2 and 6 have a system of densely distributed openings-sockets that hold rods 1 directed towards the PCB 3. Inside rod 1, a thermocouple and a heating element (resistor) is installed. In rods 1, multiple openings are drilled in parallel to the longitudinal axis of rod 1: the main cooling opening, venting openings, openings for routing the resistor power supply cables and openings for routing thermocouple cables. The ends of rods 1 are made of a ceramic material. The position of individual rods 1 is adjusted to the topography of the PCB 3 with circuit lands 4 and components 5 placed on it.

The process of soldering using the module is conducted by placing the PCB 3 between soldering plates 2 and 6, followed by the guide rails moving the soldering plates towards the PCB 3. The distance between rods 1 and circuit lands 4 and components 5 of the PCB 3 is configured based on the 3D model of the PCB 3 loaded into the computer, including the distribution of circuit lands 4, components 5 and their dimensions. After moving soldering plates 2 and 6 close to the PCB 3, resistors are heated to the temperature set-points, which results in the soldering process. Then, cooling gas flows in through the main cooling openings and out through venting openings, which ensures quick cooling of soldered areas.
The soldering process is controlled by an analysis and control system equipped with suitable software, preferably a computer that sets process parameters following the board 3D model analysis, including the solder composition, extension of heating rods from sockets and temperatures at individual heating rods.

## Claims

1. The module for soldering printed circuit boards is **characterised in that** it consists of two horizontal, parallel and movable heating plates (2) and (5), placed in enclosures made of a low thermal expansion material of 20-300°C, whereas the surface of each plate has a system of densely distributed identical openings that constitute sockets for sliding heating rods (1) with adjustable extension above the heating plate level, of which the ends are directed into the space between plates (2) and (6) and made of ceramic material or metal, whereas a rod (1) has one or more openings parallel to its longitudinal axis, in which the central opening holds a heating element and/or thermocouple, while additionally the openings constitute a duct for the gas, of which the flow is forced by a fan (7) installed at heating rod socket inlets (1), or the rod (1) has a heating element installed at its end.

2. The module according to claim 1 is **characterised in that** the sockets of heating rods (1) and the heating rods (1) are threaded.

3. The module according to claim 1 is **characterised in that** the heating element consists of a resistance wire.
